# FASCICULE DE BREVET EUROPEEN

(11) **EP 0 351 001 B1**
(45) Date de publication et mention de la délivrance du brevet: **12.10.1994**
(21) Numéro de dépôt: 89201788.0
(22) Date de dépôt: 06.07.1989
(51) Int. Cl.: H01L 21/3205, H01L 21/90, H01L 21/285

(54) **Procédé pour fabriquer un dispositif semi-conducteur ayant au moins un niveau de prise de contact à travers des ouvertures de contact de petites dimensions**
Verfahren zur Herstellung einer Halbleitervorrichtung mit mindestens einer kleine Kontaktlöcher enthaltenden Leiterbahn
Method for making a semi-conductor device with at least one level of interconnection with small dimensioned via holes

(30) Priorité: 12.07.1988 FR 8809466
(43) Date de publication de la demande: 17.01.1990
(73) Titulaire: Philips Electronics N.V., 5621 BA Eindhoven (NL)
(72) Inventeur: Penning de Vries, René, NL-5656 AA Eindhoven (NL)
(74) Mandataire: Pinchon, Pierre

(56) Documents cités:
- EP-A- 0 168 828
- EP-A- 0 202 572
- EP-A- 0 257 277
- US-A- 4 486 946
- PATENT ABSTRACTS OF JAPAN, vol. 9, no. 230 (E-343)[1953], 17 septembre 1985, page 73 E 343 ; & JP-A-60 85 514
- PROCEEDINGS OF THE 1987 VLSI MULTILEVEL INTERCONNECTION CONFERENCE, 15-16 juin 1987, pages 193-199, IEEE, New York, US; J.-J. LEE et al.: "A study of tungsten etchback for contact and via fill applications"

## Description

La présente invention concerne un procédé pour fabriquer un dispositif semiconducteur ayant au moins un niveau d'interconnexion et de prise de contact à travers des ouvertures de contact étroites élaborées dans une couche isolante supportant ce niveau d'interconnexion, procédé comportant entre autres un dépôt d'une première couche conductrice en aluminium ou en un alliage riche en aluminium par une méthode de dépôt à faible pouvoir couvrant, laissant des dépressions à l'endroit des ouvertures de contact puis un dépôt d'une seconde couche électriquement conductrice, par pulvérisation cathodique d'un alliage riche en aluminium sous une polarisation continue du substrat et le maintien de celui-ci à une température suffisamment élevée pour procurer une planarisation de cette seconde couche conductrice.

La technologie des semiconducteurs montre une évolution constante en faveur d'une intégration de plus en plus élevée du nombre de composants élémentaires dans un même circuit monolithique.

Dans ce but ainsi qu'en vue d'augmenter la rapidité de fonctionnement des dispositifs on est amené à réduire le plus possible les dimensions des composants élémentaires. Les techniques classiques de prise de contact sur les dispositifs semiconducteurs utilisaient, jusqu'à une époque récente, des ouvertures de contact et des lignes d'interconnexion dont les dimensions latérales étaient le plus souvent beaucoup plus grandes que l'épaisseur de la couche conductrice constituant lesdites lignes. En ce qui concerne la réalisation de circuits à haute densité d'intégration il est au contraire nécessaire de prévoir des ouvertures de contact dont le diamètre soit du même ordre de grandeur que l'épaisseur de la couche isolante dans laquelle ces ouvertures de contact sont pratiquées. A ce propos, on se réfère fréquemment au rapport entre la profondeur et le diamètre des ouvertures de contact, appelé rapport d'aspect, qui lorsque ce rapport est voisin de l'unité ou même supérieur, indique que les technique antérieures de prise de contact basées principalement sur le dépôt d'une unique couche d'aluminium ne peuvent plus être utilisées avec succès.

C'est ainsi que le procédé cité dans le paragraphe introductif a été proposé pour fournir une solution convenant pour la réalisation d'une configuration d'interconnexion sur un circuit à haute densité d'intégration, dans lequel les ouvertures de contact ont un rapport d'espect voisin ou supérieur à l'unité, en vue de combler les parties en dépression de la première couche conductrice en aluminium, à l'endroit des ouvertures de contact et d'assurer la continuité électrique aux marches formées par les ouvertures qui sont nécessairement assez abruptes.

Un procédé de ce type est connu du document EP-A-0 202 572.

La technique de dépôt d'aluminium ou d'alliage d'aluminium avec incorporation de cuivre et/ou de silicium par pulvérisation cathodique sous polarisation continue et maintien du- substrat à température déterminée, suffisamment élevée, permet aux espèces métalliques à déposer d'acquérir une mobilité suffisante (une distance moyenne de libre parcours) telle qu'une planarisation de la couche déposée se produit en raison du déplacement de ces espèces vers les positions de plus faible énergie.

Il s'ensuit donc un remplissage des parties en dépression laissées à la suite du dépôt de la première couche conductrice d'alliage d'aluminium.

La technique de dépôt par pulvérisation procurant une mobilité élevée des espèces à déposer est connue en tant que telle, par exemple du document EP-A-0 257 277.

Le procédé connu par le document EP-A-0 202 572 utilise également une technique très similaire.

Il est également connu des spécialistes du domaine technique que les couches d'aluminium ou d'alliage d'aluminium obtenues par ce procédé ont une résistance à l'électromigration très inférieure à celle des couches de même composition qui sont obtenues par les autres procédés plus classiques comme la pulvérisation sous argon sans polarisation continue et à température de substrat modérée. Pour cette raison, le procédé utilisant un unique dépôt métallique par pulvérisation à haute mobilité tel que proposé dans le document EP-A-0 257 277 déjà cité, apparaît difficilement applicable en raison des problèmes de fiabilité des dispositifs ainsi obtenus spécialement si on met en oeuvre des lignes d'interconnexion très étroites. En ce qui concerne les circuits à haute densité d'intégration, le problème de fiabilité se pose dans-une plus grande mesure encore.

L'invention propose un perfectionnement au procédé connu visant à atténuer dans une large mesure les difficultés précitées. Elle repose sur l'idée d'utiliser autant que possible l'aluminium ou un alliage riche en aluminium en tant que matériau pour la réalisation de la configuration d'interconnexion.

A cet effet, selon la présente invention, un procédé conforme au préambule est caractérisé en ce qu'au moins une partie substantielle de la seconde couche conductrice en dehors des dépressions est ensuite éliminée avant de former, par décapage localisé du matériau conducteur restant à la surface de la couche isolante, des lignes d'interconnexion.

Le procédé selon l'invention, a l'avantage de permettre la fabrication de dispositifs ayant une bonne résistance à l'électromigration du fait que les lignes d'interconnexion sont constituées, au moins pour l'essentiel, du matériau de la première couche conductrice qui résiste bien à l'électromigration. Le matériau de la seconde couche conductrice intervient principalement pour restituer la planéité de surface de la structure d'interconnexion et seulement en tant que complément de conduction électrique en des endroits très localisés, à savoir, dans les ouvertures de contact. Par rapport à l'utilisation de la première couche conductrice seule, la résistance à l'électromigration est améliorée à ces endroits localisés.

Le procédé selon l'invention peut être mis en oeuvre de manière particulièrement simple dans les cas d'application où la prise de contact est compatible avec la présence d'aluminium notamment pour l'élaboration d'un niveau d'interconnexion supérieur au premier niveau et alors que le niveau inférieur présente, au moins en surface, une couche où l'aluminium est le constituant principal.

Le dépôt de la première couche et le dépôt de la seconde couche conductrice peuvent être effectués à la suite l'un de l'autre dans le même appareillage, les conditions opératoires étant seulement modifiées en passant d'une couche à l'autre.

Dans un autre mode de mise en oeuvre de l'invention, dans le cas où ledit niveau d'interconnexion est un premier niveau et la prise de contact est effectuée sur des zones de contact du dispositif, le procédé se caractérise en ce qu'avant de former la première couche conductrice, on dépose d'abord une couche métallurgique de contact, relativement mince, par une méthode assurant un fort pouvoir couvrant.

Avantageusement la couche métallurgique de contact est une couche d'alliage titane-tungstène (Ti-W) déposée par pulvérisation cathodique.

Par couche relativement mince on entend désigner une couche dont l'épaisseur est une faible fraction de la plus petite dimension latérale des ouvertures de contact de sorte que la couche métallurgique de contact joue un rôle de barrière évitant toute interaction entre l'aluminium et le corps semiconducteur, mais n'assure pas le remplissage des cavités formées par les ouvertures de contact. L'alliage Ti-W est l'un des matériaux préférés actuellement pour cet usage. Il possède d'excellentes propriétés d'adhérence aux différents matériaux simultanément en présence, notamment : silicium, diélectriques tels que SiO₂, Si₃N₄, siliciure d'un métal réfractaire, etc..., il participe pour une part non négligeable à la conduction électrique de la configuration d'interconnexion et il réduit sensiblement les dégradations dues à la thermomigration.

Le procédé selon l'invention peut être mis en oeuvre en effectuant, après dépôt de la seconde couche conductrice, un retrait de celle-ci pratiquement sur la totalité de son épaisseur nominale. Par épaisseur nominale, on désigne l'épaisseur de cette couche telle qu'elle peut être mesurée sur les parties planes de la première couche d'aluminium, en dehors des ouvertures de contact.

Dans ce cas un mode particulier de mise en oeuvre de l'invention est caractérisé en ce qu'avant de former la seconde couche conductrice, on dépose sur la première couche conductrice une couche conductrice intermédiaire servant d'arrêt de décapage lors de l'étape d'élimination de la seconde couche conductrice, et en ce que cette couche intermédiaire est conservée à la surface des lignes d'interconnexion.

En pratique, la couche conductrice intermédiaire est avantageusement une couche d'alliage titane-tungstène.

On obtient ainsi que la fin de l'étape de décapage de la seconde couche conductrice peut être déterminée très facilement et on réduit le risque de formation de protubérances (hillocks) dans la première couche conductrice.

La description détaillée qui va suivre, en regard des dessins annexés, relative à des exemple non limitatifs, fera bien comprendre comment l'invention peut être réalisée.

Les figures 1 à 4 montrent des vues en coupe schématiques et partielles d'un dispositif semiconducteur au cours de différentes étapes du procédé selon l'invention, dans un premier mode de mise en oeuvre.

Les figures 5 à 7 indiquent également des vues en coupe pour des étapes du procédé selon l'invention dans un autre mode de mise en oeuvre.

Il faut noter que sur les figures représentées, les éléments ne sont pas dessinés à l'échelle, ceci pour plus de clarté.

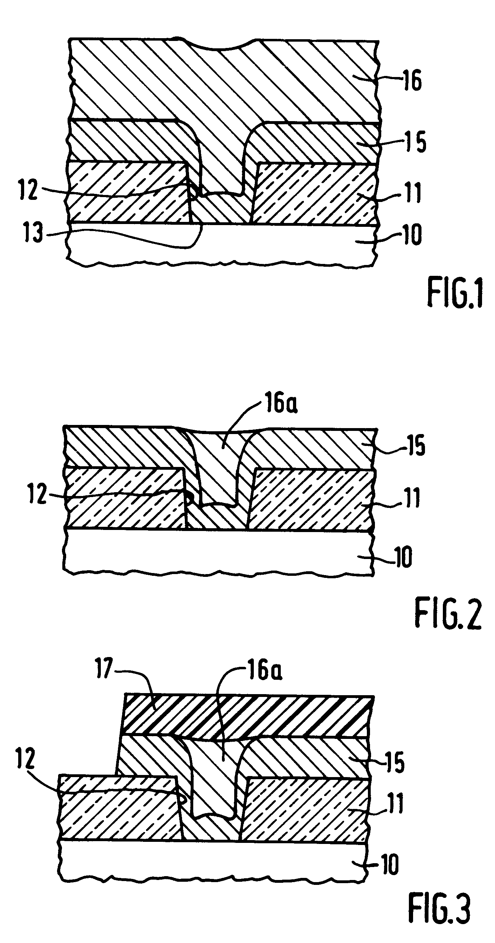

On se reporte à la figure 1 pour un premier exemple de mise en oeuvre de l'invention. Sur une couche superficielle 10 du dispositif semiconducteur, a été déposée une couche isolante 11 qui peut être par exemple en verre de silice éventuellement dopée au phosphore ou au bore.

La couche superficielle 10 peut être la surface du corps semiconducteur lui-même ou encore un niveau quelconque de métallisation sur lequel on cherche à établir un niveau de métallisation supplémentaire. Dans la couche isolante 11, on a pratiqué des ouvertures de contact 12 qui sont relativement étroites, c'est-à-dire que leur plus petite dimension latérale, est de l'ordre de grandeur de l'épaisseur de la couche isolante 11.

La gravure des ouvertures de contact 12 est effectuée au moyen d'une technique usuelle de décapage anisotrope telle qu'un décapage par plasma ou par ions réactifs de manière à obtenir des ouvertures à flancs relativement abrupts.

Le fond des ouvertures de contact 12 débouche sur des zones de contact 13 prévues à la surface de la couche superficielle 10 du dispositif semiconducteur.

Une première couche conductrice 15 à base d'aluminium, par exemple un alliage aluminium-cuivre couramment utilisé dans le domaine des semiconducteurs, est ensuite déposée au moyen d'une technique conventionnelle par exemple par pulvérisation cathodique classique. Il est connu que ce type de technique n'aboutit pas à un recouvrement uniforme des parois et du fond des ouvertures du contact 12. On choisit donc en conséquence une épaisseur de première couche conductrice 15 suffisamment mince pour que les ouvertures de contact 12 ne soient pas obturées et que cette couche ne présente pratiquement pas de pente négative (par rapport à la verticale) sur les flancs des ouvertures, mais suffisamment épaisse cependant pour que cette couche puisse assurer au moins pour l'essentiel la conduction des lignes d'interconnexions comme il sera exposé en détail ci-après.

Cette épaisseur est en général comprise entre 0,3 et 0,6µm.

On effectue ensuite le dépôt d'une seconde couche électriquement conductrice 16 par une méthode de dépôt à fort pouvoir couvrant assurant sensiblement le remplissage des parties en dépression laissées par la première couche conductrice 15 aux emplacements des ouvertures de contact 12. De ce fait la seconde couche conductrice 16 est déposée avec une épaisseur relativement forte, de l'ordre de 0,8µm par exemple.

Conformément à l'invention le dépôt de la seconde couche conductrice 16 est effectué par pulvérisation cathodique d'alluminium pur ou d'un alliage à base d'aluminium sous une polarisation continue du substrat avec le maintien de ce substrat à une température suffisamment élevée pour procurer une mobilité de surface suffisante des espèces déposées. Les conditions opératoires de ce dépôt sont réglées de manière à ce qu'une planarisation de la couche déposée se produise et conduise donc au remplissage des parties en dépression de la première couche conductrice 15. Ces conditions opératoires dépendent fortement de l'appareillage utilisé et sont donc principalement déterminées par l'expérience. En ce qui concerne la température des substrats pendant cette opération elle est choisie la plus élevée possible pour favoriser la mobilité de surface des espèces déposées mais cependant en dessous de la limite pour laquelle l'aluminium réagit avec les autres matériaux en présence et conduit alors à une détérioration irréversible du dispositif. En pratique on est amené le plus souvent à utiliser une température qui ne dépasse pas 450°C.

D'une manière générale la fixation des conditions empiriques détaillées du dépôt par pulvérisation à haute mobilité sera inspirée par les publications sur ce sujet et notamment par le document EP-A-0257277 précédemment cité, qui est incorporé ici par référence.

La figure 2 représente le résultat de l'opération suivante qui consiste à éliminer la seconde couche conductrice 16 en dehors des parties en dépression qui correspondent aux ouvertures de contact 12. L'élimination de la seconde couche conductrice 16 est de préférence effectuée au moyen d'un décapage anisotrope par ions réactifs ou dans un plasma. La durée de ce décapage est déterminée par l'expérience à partir de l'épaisseur nominale de la seconde couche conductrice 16 et de la vitesse de décapage. Ce décapage laisse subsister un élément localisé 16a de la seconde couche conductrice qui effectue le remplissage des cavités à l'endroit des ouvertures des contacts 12.

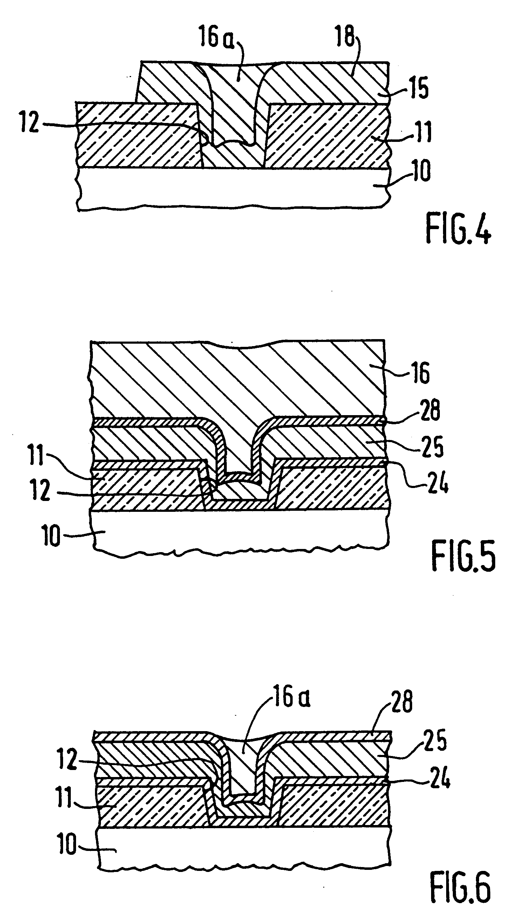

Les opérations suivantes sont illustrées au moyen des figures 3 et 4 et elles consistent à réaliser la configuration d'interconnexion en utilisant un masque de laque photosensible 17 et un décapage localisé de la première couche conductrice 15. Comme il s'agit ici de la gravure d'une couche d'aluminium ou d'un alliage d'aluminium, ces opérations font appel à des techniques courantes dans le domaine des semiconducteurs et n'ont pas besoin d'être décrites en détail.

On peut observer à la figure 4 que les lignes d'interconnexion telles que 18 sont exclusivement formées à partir de la première couche conductrice 15 et sont donc constituées d'un matériau qui résiste convenablement à l'électromigration. Les éléments localisés 16a de la seconde couche conductrice constitués d'un matériau qui résiste moins bien à l'électromigration, interviennent dans une très faible proportion de la configuration d'interconnexion. Ils procurent une bonne planéité de surface de la métallisation et réduisent la densité de courant à l'emplacement des ouvertures de contact par rapport à celle qui se produirait en l'absence de ces éléments localisés 16a.

Le dispositif semiconducteur fait ensuite l'objet d'opérations de finition qui sont du domaine courant de la technique. On peut si on le désire créer des niveaux supplémentaires d'interconnexion pour lesquels il est possible d'utiliser avantageusement le procédé selon l'invention.

Le procédé décrit jusqu'ici lorsqu'il est appliqué pour constituer un premier niveau d'interconnexion avec prise de contact sur les zones de contact du dispositif lui-même, peut avantageusement être modifié comme suit.

Avant de former la première couche conductrice 15 en aluminium ou en alliage d'aluminium on dépose d'abord une couche métallurgique de contact relativement mince en utilisant une méthode assurant un fort pouvoir couvrant. Un choix particulièrement convenable consiste à utiliser une couche d'alliage titane-tungstène déposée par pulvérisation cathodique. Cette couche métallurgique de contact joue un rôle de barrière évitant toute interaction entre la couche d'aluminium déposée au stade suivant du procédé et le corps semiconducteur. Elle n'assure pas le remplissage des cavités formées par les ouvertures de contact 12 mais participe dans une certaine mesure à la conduction du système d'interconnexion.

Elle permet d'abaisser la résistance de contact avec le corps semiconducteur, elle évite les piqûres de surface du semiconducteur par l'aluminium et réduit également l'apparition de nodules dans la première couche conductrice.

A la suite du dépôt de la couche métallurgique de contact, les étapes suivantes du procédé précédemment décrites en liaison avec les figures 1 à 4 restent pratiquement inchangées. Ainsi la description fournie à propos de ces figures s'applique encore à la présente variante en considérant que la première couche conductrice 15 est une double couche Ti-W/Al-Cu. Bien entendu l'opération consistant à découper la configuration d'interconnexion par décapage localisé est maintenant effectuée en deux étapes successives, l'une de décapage spécifique de la partie de première couche conductrice qui est en alliage d'aluminium et l'autre de la partie de couche qui est en alliage titane-tungstène. En réalité ces deux attaques successives peuvent être réalisées successivement dans le même appareillage de décapage par ions réactifs ou par plasma avec une simple interruption du processus pour modifier les conditions de décapage et notamment le composé gazeux introduit dans le plasma.

On va maintenant décrire un autre mode de mise en oeuvre du procédé selon l'invention à l'aide des figures 5 à 7. Conformément à la figure 5, la couche superficielle du dispositif semiconducteur 10 est surmontée d'une couche isolante 11 dans laquelle ont été pratiquées des ouvertures de contact 12 relativement étroites. On dépose ensuite une couche métallurgique de contact 24 assez mince, de préférence mais non exclusivement en alliage Ti-W, puis une première couche conductrice 25 en alliage d'aluminium le tout d'une manière conforme à la description donnée précédemment. On dépose ensuite une couche conductrice intermédiaire 28 servant d'arrêt de décapage lors de l'étape d'élimination de la future seconde couche conductrice 16, cette couche 28 étant de préférence en Ti-W, déposée par pulvérisation cathodique. La couche conductrice intermédiaire 28 est d'épaisseur faible de préférence comprise entre 50 et 150 nm.
L'épaisseur de l'ensemble des couches 24, 25 et 28 est également suffisamment faible pour ne pas remplir entièrement les cavités formées à l'emplacement des ouvertures de contact 12. On dépose ensuite la seconde couche conductrice 16 en alliage Al-Cu par la méthode de pulvérisation à haute mobilité utilisant une polarisation continue du substrat telle qu'indiquée précédemment. La seconde couche conductrice 16 est suffisamment épaisse pour réaliser le remplissage des cavités formées à l'emplacement des ouvertures de contact 12 et réaliser une planarisation approximative de sa surface supérieure. Il est a noter que dans cet exemple de mise en oeuvre, le procédé comporte un plus grand nombre d'étapes de dépôt mais toutefois l'homogénéité des techniques mises en oeuvre ne requiert que des appareillages similaires, voire un appareillage unique.

On procède ensuite (figure 6) à l'élimination totale de la seconde couche conductrice 16 à l'exception des portions localisées 16a situées aux emplacements des ouvertures de contact 12. Dans cette opération, la couche conductrice intermédiaire 28 sert d'arrêt de décapage et rend plus précise et plus simple la fin de cette opération qui peut être contrôlée par les moyens habituels par exemple par l'intensité d'émission d'une raie particulière du plasma.

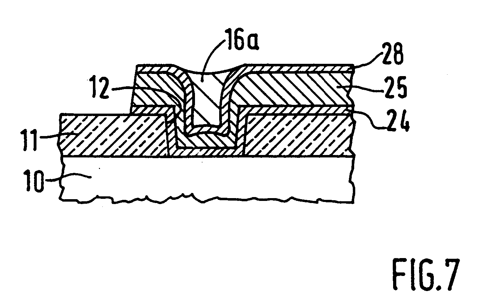

La figure 7 représente la structure d'interconnexion après qu'elle ait été formée par décapage localisé de l'ensemble des couches 28, 25 et 24. Bien entendu, les conditions de décapage sont appropriées à chaque fois à la nature des couches à éliminer. En particulier les couches constituées de l'alliage Ti-W sont éliminées dans un plasma d'hexafluorure de soufre tandis que la couche 25 en alliage d'aluminium est éliminée dans un plasma d'un composé gazeux du chlore.

Selon cette variante du procédé, comme il est indiqué à la figure 7, la couche conductrice intermédiaire 28 est avantageusement conservée pour la formation des lignes d'interconnexion et participe donc à la conduction de ces lignes. De même que dans les exemples précédents, la partie localisée 16a qui a été conservée de la seconde couche conductrice 16 est limitée au remplissage de la cavité située à l'emplacement de l'ouverture de contact 12 et sa participation au transport de courant reste faible. Ceci explique que le système d'interconnexion et de prise de contact ainsi réalisé montre de bonnes performances en ce qui concerne l'électromigration. Un autre avantage de ce procédé est fourni par la présence de la couche 28 en alliage Ti-W qui réduit d'une manière notable les possibilités de formation de protubérances dans la première couche conductrice 25 en alliage d'aluminium qui sont susceptibles de se produire au cours des traitements thermiques ultérieurs.

Le procédé selon l'invention ne saurait se limiter aux exemples décrits précédemment. En particulier, l'alliage Ti-W a été indiqué comme matériau préféré pour réaliser la couche métallurgique de contact 24 ainsi que pour la couche conductrice intermédiaire 28. D'autres matériaux peuvent également être utilisés dans ce but, par exemple un alliage de tungstène-silicium, du titane, du nitrure de titane, du cobalt, ou un siliciure de métal réfractaire. Pour plus de simplicité, on peut recourir au même matériau pour réaliser la couche métallurgique de contact et la couche conductrice intermédiaire. Mais on peut également, si on le désire, utiliser des matériaux différents dans chacun des cas.

Un choix convenable du matériau de la couche conductrice intermédiaire et de son épaisseur peut également permettre de réduire la réflexion de la lumière sur la couche métallique lors de l'opération de photogravure de la configuration de contact.

On sait en effet que cette réflexion optique produit des défauts de définition du masquage dans le voisinage des parties non horizontales de la couche métallique (franchissement de marches).

En ce qui concerne l'épaisseur de la première couche conductrice 15, 25 en alliage d'aluminium, il est pratiquement nécessaire d'éviter de former une pente trop négative sur les parois des ouvertures de contact. On peut penser que cela constitue une limitation importante dans le choix de l'épaisseur nominale de cette couche et donc de restreindre de manière peu pratique le pouvoir de conduction des lignes d'interconnexion. Pour obtenir le meilleur compromis technologique sur ce point, en utilisant le procédé de l'invention, qui comporte par ailleurs les avantages importants déjà mentionnés, on utilisera les techniques connues qui permettent de retarder la formation de pentes négatives lors du dépôt de la première couche conductrice, par exemple en produisant une légère pente positive ou un arrondissement des flancs des ouvertures de contact, et en choisissant les conditions de dépôt de cette couche qui sont les plus favorables.

## Revendications

1. Procédé pour fabriquer un dispositif semiconducteur ayant au moins un niveau d'interconnexion et de prise de contact à travers des ouvertures de contact (12) étroites élaborées dans une couche isolante (11) supportant ce niveau d'interconnexion, procédé comportant entre autres un dépôt d'une première couche conductrice (15) en aluminium ou en un alliage riche en aluminium par une méthode de dépôt à faible pouvoir couvrant, laissant des dépressions à l'endroit des ouvertures de contact puis un-dépôt d'une seconde couche (16) électriquement conductrice, par pulvérisation cathodique d'un alliage riche en aluminium sous une polarisation continue du substrat et le maintien de celui-ci à une température suffisamment élevée pour procurer une planarisation de cette seconde couche conductrice, caractérisé en ce que la seconde couche conductrice (16) en dehors des dépressions est ensuite éliminée pratiquement sur la totalité de son épaisseur nominale avant de former, par décapage localisé du matériau conducteur restant à la surface de la couche isolante, des lignes d'interconnexion (18).

2. Procédé selon la revendication 1 dans lequel ledit niveau d'interconnexion est un premier niveau et la prise de contact est effectuée sur des zones de contact (13) du dispositif, caractérisé en ce qu'avant de former la première couche conductrice (25), on dépose d'abord une couche métallurgique de contact (24), relativement mince, par une méthode assurant un fort pouvoir couvrant.

3. Procédé selon la revendication 2, caractérisé en ce que ladite couche métallurgique de contact (24) est une couche d'alliage titane-tungstène déposée par pulvérisation cathodique.

4. Procédé selon l'une quelconque des revendications 1 à 3, caractérisé en ce qu'avant de former la seconde couche conductrice (16), on dépose sur la première couche conductrice (25) une couche conductrice intermédiaire (28) servant d'arrêt de décapage lors de l'étape d'élimination de la seconde couche conductrice (16), et en ce que cette couche intermédiaire (28) est conservée à la surface des lignes d'interconnexion.

5. Procédé selon la revendication 4, caractérisé en ce que la couche conductrice intermédiaire (28) est une couche d'alliage titane-tungstène.

6. Procédé selon l'une quelconque des revendications 1 à 5 caractérisé en ce que l'épaisseur nominale de la première couche conductrice (15), (25) est choisie à une valeur comprise entre 0,3 et 0,6µm.

## Patentansprüche

1. Verfahren zur Herstellung einer Halbleiteranordnung, die mindestens eine Verdrahtungs- oder Kontaktierungsebene mit Kontaktlöchern (12) kleiner Abmessungen enthält, wobei diese Löcher in die diese Verdrahtungsebene tragende Isolierschicht (11) eingebaut sind und wobei dieses Verfahren unter anderem das Aufbringen einer ersten leitenden Schicht (15) aus Aluminium oder aus einem stark aluminiumhaltigen Material mittels eines wenig benetzenden Beschichtungsverfahrens dergestalt, daß an den Kontaktlöchern Vertiefungen erhalten bleiben, enthält und daran anschließend das Aufbringen mittels Kathodenzerstäubung einer zweiten elektrisch leitenden Schicht (16) aus einer stark aluminiumhaltigen Legierung mit konstanter Vorspannung des Substrats und mit Erhitzung dieses Substrats auf eine ausreichend hohe Temperatur, so daß diese zweite leitende Schicht eben wird, dadurch gekennzeichnet, daß die zweite leitende Schicht (16), ausgenommen an den Vertiefungen, praktisch in ihrer gesamten Nennstärke entfernt wird, bevor durch lokales Abätzen des Leitermaterials auf der Oberfläche der Isolierschicht die Verdrahtungsleiterbahnen (18) gebildet werden.

2. Verfahren nach Anspruch 1, bei dem die Verdrahtungsebene eine erste Ebene darstellt und die Kontaktierung an Kontaktflächen (13) der Anordnung erfolgt, dadurch gekennzeichnet, daß vor Aufbringen der ersten leitenden Schicht (25) zunächst eine relativ dünne metallische Kontaktschicht (24) mit einem stark benetzenden Verfahren aufgebracht wird.

3. Verfahren nach Anspruch 2, dadurch gekennzeichnet, daß die metallische Kontaktschicht (24) aus einer Titan-Wolfram-Legierung besteht, die durch Kathodenzerstäubung aufgebracht wird.

4. Verfahren nach einem der Ansprüche 1 bis 3, dadurch gekennzeichnet, daß vor Aufbringen der zweiten leitenden Schicht (16) auf der ersten leitenden Schicht (25) eine leitende Zwischenschicht (28) aufgebracht wird, die als Ätzstoppschicht beim anschließenden Abätzen der zweiten leitenden Schicht (16) dient, und daß diese leitende Zwischenschicht (28) auf der Oberfläche der Verdrahtungsleiterbahnen erhalten bleibt.

5. Verfahren nach Anspruch 4, dadurch gekennzeichnet, daß die leitende Zwischenschicht (28) aus einer Titan-Wolfram-Legierung besteht.

6. Verfahren nach einem der Ansprüche 1 bis 5, dadurch gekennzeichnet, daß als Nennstärke für die erste leitende Schicht (15), (25) ein Wert zwischen 0,3 µm und 0,6 µm gewählt wird.

## Claims

1. A method of manufacturing an integrated semiconductor device having at least one interconnection level making contact connection through narrow contact openings (12) formed in an insulating layer (11) supporting this interconnection level, this method comprising inter alia a step of depositing a first conductive layer (15) of aluminium or an alloy rich in aluminium by a deposition method having a poor step covering ability, leaving depressions at the areas of the contact openings, a step of depositing a second electrically conductive layer (16) by cathode sputtering of an alloy rich in aluminium while the substrate is kept under a DC bias voltage and at a sufficiently high temperature for obtaining a planarization of said second conductive layer, characterized in that the second conductive layer (16) is subsequently eliminated outside the depressions through substantially its full nominal thickness before interconnection lines (18) are formed by local etching of conductive material remaining at the surface of the insulating layer.

2. A method as claimed in Claim 1, in which the said interconnection level is a first level and the contact connection is formed on contact zones (13) of a device, characterized in that, before the first conductive layer (25) is formed, first a comparatively thin metallurgic contact layer (24) is deposited by a method ensuring a good step coverage.

3. A method as claimed in Claim 2, characterized in that the said metallurgic contact layer (24) is a layer of a titanium-tungsten alloy deposited by cathode sputtering.

4. A method as claimed in any one of the preceding Claims, characterized in that, before the second conductive layer (16) is formed, an intermediate conductive layer (28) serving as an etching stopper during the step of eliminating the second conductive layer (16) is deposited on top of the first conductive layer (25), and in that this intermediate layer (28) is maintained at the surface of the interconnection lines.

5. A method as claimed in Claim 4, characterized in that the intermediate conductive layer (28) is a layer of a titanium-tungsten alloy.

6. A method as claimed in any one of Claims 1 to 5, characterized in that the nominal thickness of the first conductive layer (15, 25) is chosen at a value lying between 0.3 and 0.6 µm.
